Europäisches Patentamt

European Patent Office

Office européen des brevets

(19)

(11) Publication number: **0 167 884**
**A2**

(12)

# EUROPEAN PATENT APPLICATION

(21) Application number: **85107489.8**

(22) Date of filing: **18.06.85**

(51) Int. Cl.⁴: **H 02 H 9/02**

(30) Priority: **09.07.84 IT 4571684**

(43) Date of publication of application:
**15.01.86 Bulletin 86/3**

(84) Designated Contracting States:
**AT BE CH DE FR GB IT LI LU NL SE**

(71) Applicant: **Zanussi Elettromeccanica S.p.A.**
**Via Giardini Cattaneo 3**
**I-33170 Pordenone(IT)**

(72) Inventor: **de Marco, Doreano**
**Frazione Brusadaz 29/B**
**I-32010 Zoldo Alto, Belluno(IT)**

(72) Inventor: **Zambelli, Michele**
**viale Cadore 21/F**
**I-32014 Ponte Nelle Alpi, Belluno(IT)**

(72) Inventor: **Balbinot, Bruno**
**via G. Galilei 25**
**I-31029 Vittorio Veneto, Treviso(IT)**

(74) Representative: **Patentanwälte Grünecker, Kinkeldey,**
**Stockmair & Partner**
**Maximilianstrasse 58**
**D-8000 München 22(DE)**

(54) DC supply unit with overcurrent protection.

(57) The voltage drop at the terminals of a measuring resistor (3) connected in series in the outlet current path (2) of a DC supply unit controls a threshold value circuit (7, 13) operable to disconnect the supply unit when the current flowing through the resistor (3) exceeds a certain value.

The measuring resistor comprises a parasitic resistance represented by a section of the output current path.

In the case of the supply unit being at least partially formed as a printed circuit, the measuring resistance (3) preferably comprises a section of a conductor path.

EP 0 167 884 A2

Description

The present invention relates to a DC supply unit of the type having an automatic overcurrent protection device. More particularly, the invention is directed to a supply unit for supplying direct current at an intermediate value, for instance more than 10 Amps.

Known already are various types of overcurrent protection devices for DC supply units; these protection devices differ mainly by the various methods for measuring the controlled current output of the supply unit. The most simple and accurate solution, which is therefore in common use, consists in determining the voltage drop over a measuring resistor connected in series in the current output path of the supply unit.

The voltage drop at the terminals of the measuring resistor is employed to control, through a suitable amplifier, a comparator having a predetermined threshold value, on exceeding which a switch circuit is activated for interrupting operation of the supply unit.

As generally known, satisfactory regulation of the entire supply unit requires the measuring resistor to have a particularly low ohmic value. It is also known that the lowest ohmic value (about o.033$\Omega$ )of commercially available resistors is not yet sufficiently low for achieving a satisfactory regulation of the control unit, particularly in the case of stronger currents. For resons of cost, reliability, functional uniformity and practicability it is unthinkable to employ, on an industrial level, a plurality of parallel-connected resistors, or a measuring resistor requiring highly sophisticated manufacturing techniques, in a supply unit of the type described.

On the other hand, a further reduction of the ohmic value of the measuring resistor is practically indispensable in the case of DC supply units having relatively strong output currents of for instance more than 10 Amps.

A main object of the invention is therefore the provision of a DC supply unit with overcurrent protection of the type comprising a series-connected measuring resistor, which is capable of providing an optimum degree of regulation.

Another object of the invention is the provision of a supply unit of the type defined above which is capable of providing an optimum degree of regulation even in the case of relatively strong output currents.

According to the invention, these objects are attained in a DC supply unit with overcurrent protection, comprising a measuring resistor connected in series in the output current path of the supply unit. The voltage drop at the terminals of the resistor controls a threshold value protection means adapted to disconnect the supply unit when the current flowing through said resistor exceeds a predetermined value.

The supply unit is mainly characterized in that said measuring resistor comprises a parasitic resistance represented by at least a section of said output current path. In the case that at least part of the electric circuit of the supply unit is formed as a printed circuit, said section of the output current path is preferably formed by a conductor path of the printed circuit.

The supply unit according to the invention is thus particularly simple and reliable in operation. Although the described arrangement requires a suitable measuring resistor, or resistance (which is indispensable for a satisfactory regulation), to be connected in series in the output current path of the supply unit, the invention makes advantageous use of the parasitic effect necessarily present in the circuit.

It has been experimentally shown that, according to the invention, it is possible to readily obtain a measuring resistance at values of only a few m$\Omega$.

As a result, the regulation degree of the supply unit remains very high even in the case of a very high current output, so as to attain the object of the invention.

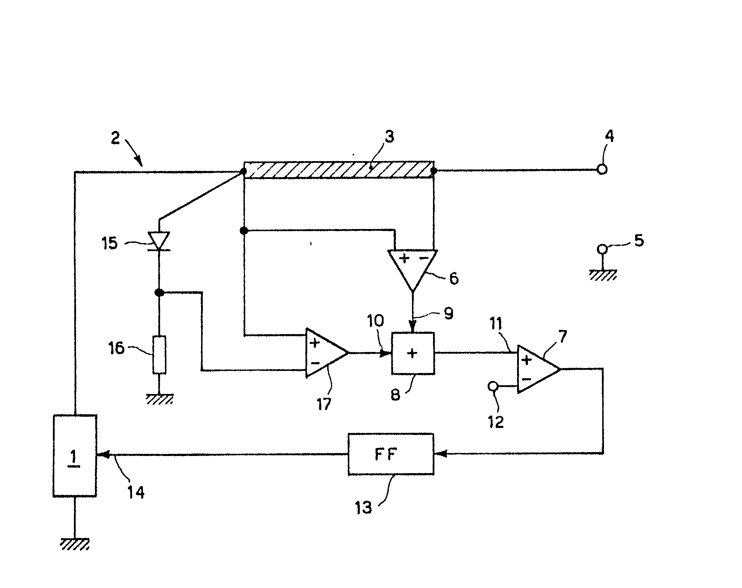

The advantages and characteristics of the invention will become more clearly evident from the following description, given by way of example with reference to the accompanying drawings, the only figure of which shows a diagrammatic representation of a preferred embodiment of the supply unit according to the invention.

The supply unit shown comprises in the first place a current source 1 adapted to supply a DC current via an output current path 2 including a series-connected resistor, or resistance 3. Output current path 2 terminates in a terminal 4 cooperating with a second grounded terminal 5 to form the current outlet of the supply unit.

The terminals of measuring resistance 3 are connected to respective input terminals of a differential amplifier 6 the output of which controls a threshold value stage, for instance a comparator circuit 7. More particularly, the output of amplifier 6 is connected to an input terminal 9 of a summing stage 8, the output of which is connected to a control input terminal 11 of the comparator 7. A second input terminal 12 of comparator 12 is to be understood to have applied thereto a reference voltage proportional to the maximum admissible current flowing through measuring resistance 3.

In a per se known manner the output of comparator 7 controls a bistable switching circuit 13 operatively connected to a control input terminal 14 of current source 1. The latter may for instance comprise a controlled rectifier with associated filtering and levelling circuits. The general operation of the supply unit is known, as described above.

According to one aspect of the invention, the measuring resistance 3, instead of being in the form of a conventional electric component, comprises a parasitic resistance represented by at least a section of the output current path 2 of the supply unit. In the preferred case, in which at least part of the supply unit is mounted on a printed circuit board, the parasitic resistance is advantageously represented by at least a section of a conductor path forming a part of output current path 2.

The ohmic value of measuring resistance 3 may thus readily be selected at a very low level. Depending for example on the thickness and width of the respective conductor path, a portion of a few centimetres length of this conductor path may be employed as the measuring resistance 3 having an ohmic value of about 2 m$\Omega$.

As the conductor paths of a printed circuit are usually formed of copper (a material having a resistivity with a relatively high positive temperature coefficient), it is advisable for the supply unit according to the invention to be thermically compensated.

This may be accomplished by the use of a simple diode 15, or a similar temperature transducer, branch-connected to the output current path 2.

In particular, the cathode of diode 15 is connected to ground through a polarizing resistor 16, while the anode is directly connected to any point of measuring resistance 3 and bodily located a small distance (of for instance a few millimetres) from the resistance itself so as to sense the temperature thereof.

The anode of diode 15 is preferably connected to a terminal of measuring resistance 3 as shown in the drawing. As generally known, the voltage drop at the terminals of diode 15 (which is always negligible with regard to the operation of the supply unit) varies with changes in temperature  As a result, the voltage drop at the output terminal of diode 15 is proportional to the temperature of the measuring resistance 3; this output voltage drop is applied to the input terminals of a further differential amplifier 17, the output terminal of which is connected to a second input terminal 10 of summing circuit 8. By suitably dimensioning and adapting amplifiers 6 and 17 it is thus readily possible to obtain at the output terminal of summing circuit 8 a thermically compensated output signal proportional to the actual current flow through measuring resistance 3.

The described supply unit may obviously modified in any required manner within the scope of the invention.

In the case for example of a supply unit designed for supplying a particularly strong direct current in the order of hundreds of Amps, the electric connections will be formed as a conventional wiring arrangement instead of a printed circuit. In this case the parasitic measuring resistance will be represented by a section of the electric output cable of the supply unit.

0167884

A GRUNECKER
DR H KINKELDEY
DR W STOCKMAR
DR K SCHUMANN
F H JAKOB
DR G BEZOLD
W MEISTER
H HILGERS
DR H MEYER PLATH
DR M BOTT BODENHAUSEN
DR U KINKELDEY

*LICENCIE EN DROIT DE L UNIV DE GENEVE

8000 MUNCHEN 22
MAXIMILIANSTRASSE 56

EP 2416

## DC Supply Unit with Overcurrent Protection

P a t e n t   C l a i m s

1. A DC supply unit with overcurrent protection, comprising a measuring resistor connected in series in the output current path of the supply unit, the voltage drop at the terminals of said resistor controlling a threshold value protection device adapted to disconnect said supply unit when the current through said measuring resistor exceeds a predetermined value, characterized in that said measuring resistor (3) comprises a parasitic resistance represented by at least a section of said output current path (2).

2. A supply unit according to claim 1, wherein at least part of the electric circuit of the supply unit is formed as a printed circuit, characterized in that said section (3) of said output current path (2) is formed by a conductor

3.    A supply unit according to claim 1, characterized by further comprising a thermic transducer (15) branch-connected to said section (3) of said output current path (2), the output voltage of said transducer being adapted to control said threshold value protection device (6-10, 13, 14, 17) with a thermic compensation signal in a per se known manner.